# EUROPEAN PATENT SPECIFICATION

(11) **EP 2 381 503 B1**
(45) Date of publication and mention of the grant of the patent: **17.04.2013**
(21) Application number: 10160948.5
(22) Date of filing: 23.04.2010
(51) Int. Cl.: B29C 47/10, B29C 47/00, H01L 51/00, H01L 51/56

(54) **Method for manufacturing material for use in manufacturing electroluminescent organic semiconductor devices**
Verfahren zur Herstellung von Material zur Verwendung bei der Herstellung von elektrolumineszenten organischen Halbleiterbauelementen
Procédé pour la fabrication de matériau pour une utilisation pour la fabrication de dispositifs semi-conducteurs électroluminescents organiques

(43) Date of publication of application: 26.10.2011
(73) Proprietor: Polyphotonix Limited, Sedgefield County, Durham TS21 3FG (GB)
(72) Inventor: Veres, Janos, Durham, TS21 3FG (GB)
(74) Representative: Harrison Goddard Foote

(56) References cited:
- EP-A1- 1 965 451
- EP-A1- 2 017 306
- EP-A2- 1 391 944
- WO-A1-2004/052619
- US-A1- 2006 270 100

## Description

The present invention relates to a method and apparatus for manufacturing a material for use in manufacturing organic semiconductor devices, and relates particularly, but not exclusively, to a method and apparatus for manufacturing a material for use in manufacturing functional films in organic semiconductor devices.

Organic semiconductor (OSC) materials are used to make functional films in organic semiconductor devices, for example organic light emitting diodes (OLED) for use in lighting, displays or signage.

Organic semiconductor (OSC) materials have particular application in the fabrication of large area or flexible devices, organic thin film transistors (OTFT), organic light emitting diodes (OLED) and sensors. In such devices, OSC materials are present as thin films (typically a few nanometers to micrometers in thickness) and perform a switching, photoelectric or sensing function. Such devices can use one or more functional layers consisting of various organic semiconductors, and sometimes blends of more than one semiconductor material.

The materials used in OSC films have optical and/or electronic functionality such as luminescence, electroluminescence, phosphorescence, charge transport or charge injection, and the thickness of a particular layer is determined by its functionality. A typical layer thickness used in OLED is between a few nanometers and a micron. Most layers are typically 10 to 100 nanometers thick, which presents significant challenges to their uniform deposition. This can be further complicated by the necessity to combine several materials in each functional layer and distribute the materials in the layer uniformly. The two techniques commonly used to deposit OLED materials are (i) vacuum evaporation and (ii) solution coating.

In vacuum evaporation, the OSC material is heated until it vaporises and subsequently condenses on a target substrate. Although this technique has the advantage that extremely thin films can be formed, it has the drawback that vacuum evaporation of organic materials can necessitate the heating of organic materials in a crucible for an extended period (possibly hours or days), often resulting in decomposition of the material. In addition this technique has the disadvantage that depositing a blend of different materials is not a straightforward process, since materials often have different vapour pressures, as a result of which controlling the rate of deposition for each component can be complex and difficult. This can make the proportion ratio of different components in the final film very difficult to control. This technique also suffers from the drawback that the organic materials used, which can be extremely expensive, are partially deposited on the internal walls of the heating chamber, as a result of which significant amounts of material are wasted.

In solution coating, organic semiconductor materials are dissolved or dispersed in a solvent to form a coating liquid, which is then subsequently coated onto a substrate by spin coating, slit die coating or other techniques such as printing, and the coating then dried to remove the solvent. Although less material is wasted in this technique than in vacuum evaporation, particularly for continuous web coating, solution coating suffers from the drawback that it can be difficult to coat an organic layer from a solvent without dissolving or disturbing another organic layer underneath the layer to be coated. Also, the use of large quantities of environmentally harmful solvents such as aromatic, chlorinated or alcohol solvents, is undesirable, and many high performance materials are not soluble in solvents and therefore cannot be used in solution coating processes.

EP 1391944 discloses a method according to the preamble of claim 1.

Preferred embodiments of the present invention seek to overcome one or more of the above disadvantages of the prior art.

According to the present invention, there is provided a method of manufacturing a precursor material for use in preparing at least one electroluminescent organic semiconductor device, the method characterised by melting at least one first organic semiconductor material including at least one electroluminescent material, and mixing at least one further material with the or each said first organic semiconductor material.

The present invention is based on the surprising discovery that by processing organic semiconductor materials from their molten states, it is possible to overcome several of the above disadvantages, and the precursor material can either directly feed in molten form a process for forming a functional layer of organic semiconductor material, or can be formed into a suitable solid form and subsequently remelted to form a functional layer. This enables more accurate control of the ratio of different components in the functional layer produced using the material of the present invention, substantially eliminates the use of harmful aromatic, chlorinated or alcohol solvents and enables materials which are not soluble in solvents to be processed. In addition, the process can be carried out at lower temperatures than those required for vacuum evaporation, as a result of which the extent of degradation of the organic semiconductor material is minimised.

The step of melting at least one said first organic semiconductor material may be carried out in the presence of at least one gas for minimising oxidation of at least one said first organic semiconductor material.

At least one said gas may comprise an inert gas and/or nitrogen.

At least one said further material may be a plasticiser adapted to reduce the melting temperature of at least one said first organic semiconductor material.

This provides the advantage of minimising the extent to which degradation of the material occurs, and enabling the use of materials that are sensitive to high temperatures and which would normally decompose before reaching their melting point.

The plasticiser may comprise carbon dioxide.

The plasticiser may comprise at least one supercritical fluid.

This provides the advantage of providing solvent-type behaviour without the use of harmful aromatic, chlorinated or alcohol solvents.

The method may further comprise the step of removing at least some of said plasticiser subsequently to mixing thereof with at least one said first organic semiconductor material.

This provides the advantage of minimising the formation of bubbles or irregularities in a functional layer formed directly from the molten precursor material.

At least some of said plasticiser may be removed by controlling the temperature and/or pressure of the melted material.

At least one said further material may comprise at least one second organic semiconductor material.

By blending at least one first and at least one second organic semiconductor material in melted form, this provides the advantage of enabling a wider range of composite materials to be made, for example because non-soluble materials can be mixed in melted form. Also, the blending process can under certain circumstances take place at lower process temperatures. For example, by adding a second semiconductor material having a higher melting point in solid form to molten first semiconductor material having a lower melting point, the overall melting point of the combined material can under certain circumstances be brought below that of the second semiconductor material. As a result, blending can occur at lower process temperatures, thereby minimising the extent of degradation of the material.

At least one said further material may be added in solution form.

This provides the advantage of enabling accurate control of the concentration of said further material, particularly when said further material is added in small quantities.

At least one said first organic semiconductor material may include at least one charge transport material.

At least one said further material may be added in solid form to at least one said first organic semiconductor material.

The method may further comprise mixing at least one said first organic semiconductor material and at least one said further material by means of at least one screw extruder apparatus.

This provides the advantage of enabling the mixing process to be carried out as a continuous (i.e. as opposed to a batch) process, with minimum residence time of materials in the mixing apparatus.

At least one said screw extruder apparatus may provide alternating zones of high and low shear.

At least one said screw extruder apparatus may include at least one cavity transfer mixer.

Preferred embodiments of the invention will now be described, by way of example only and not in any limitative sense, with reference to the accompanying drawings in which:
Figure 1 is a schematic side cross-sectional view of a first mixer for carrying out a process embodying the present invention; and
Figure 2 is a schematic side cross-section view of a second mixer for carrying out a process embodying the present invention.

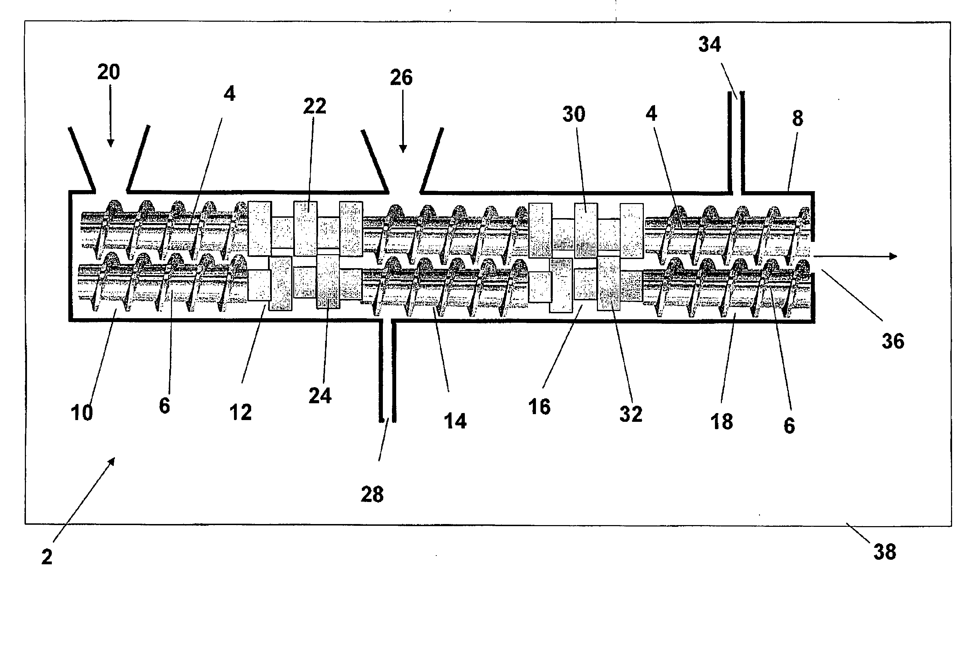

Referring to Figure 1, a twin screw extruder mixer 2 for carrying out a mixing process embodying the present invention has interleaved first 4 and second 6 screws arranged in a housing 8 defining first 10, second 12, third 14, fourth 16 and fifth 18 zones, the temperature in each of which can be independently controlled. A first inlet 20 receives a first component of the blended material which has a lower melting point, for example an organic semiconductor material such as a hole transporting organic semiconductor, N,N'-Bisphenyl-N,N'-bis(3-methylphenyl)-benzidine (TPD) having a melting point of approximately 170°C.

The temperature and pressure increases in the first zone 10, and then high pressure mixing occurs in the second zone 12 as a result of first 22 and second 24 sets of interleaved mixing wheels or paddles on the first 4 and second 6 screws respectively. A second component of the blended material, having higher melting point than the first component, such as Bisphenol-A polycarbonate (PCA), having a melting point of approximately 250°C is introduced into the third zone 14, where the temperature and pressure are increased in a similar manner to in the first zone 10, through a second inlet 26. If further materials need to be added in small proportions, they can be added in solution via a third inlet 28 to the third zone 14. High pressure mixing then occurs in the fourth zone 16 by means of first 30 and second 32 sets of interleaved mixing wheels or paddles on the first 4 and second 6 screws respectively, in a manner similar to the second zone 12. The temperature and pressure then increases in the fifth zone 18 and solvent previously introduced through the third inlet 28 evaporates from the composite material through an escape vent 34, and the molten mixed material is then dispensed through an outlet port 36. Alternatively, a plasticiser in the form of supercritical carbon dioxide can be introduced into the mixer via inlet 28 at elevated pressures between 10 to 300bar, and preferably between 80 and 150bar. An escape vent 34 allows CO2 to evaporate from the composite material and after mixing the final blended precursor material is then dispended through an outlet port 36.

The extruder mixer 2 is located within an inert enclosure 38 containing nitrogen or an inert gas, in order to minimise the extent of oxidation of the organic semiconductor materials.

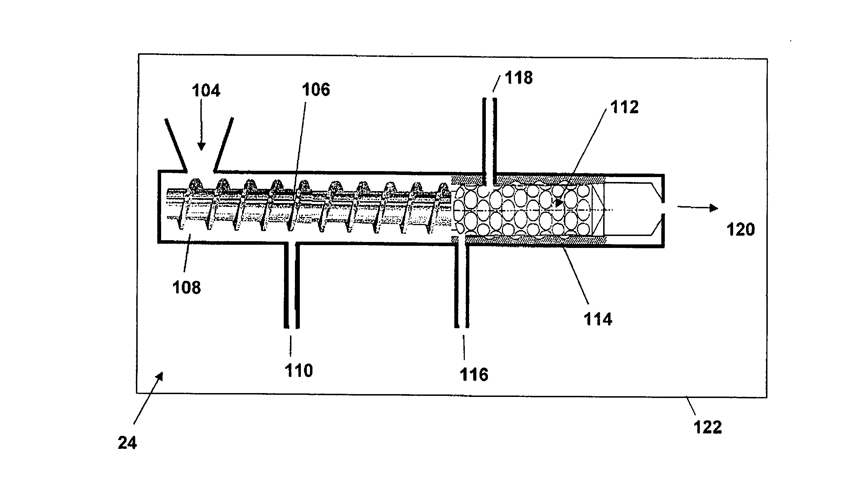

Referring to Figure 2, a single screw extruder mixer 102 for carrying out a process embodying the present invention has a first inlet 104 for receiving one or more components of solid organic semiconductor material and a screw assembly 106 increases the temperature and pressure of the materials in a first zone 108 of the mixer 2, and further components can be introduced in solution through a second inlet 110.

The screw assembly 106 feeds material into a cavity transfer mixer (CTM) 112 provided in a second zone 114 of the mixer, and further components can be introduced in solution through a third inlet 116. A plasticiser in the form of supercritical carbon dioxide is introduced into the CTM 112 via a fourth inlet 118 at elevated pressures between 10 to 300bar, and preferably between 80 and 150bar. An escape vent (not shown) allows CO2 to evaporate from the composite material and after mixing the final blended precursor material is then dispended through an outlet port 120. The mixer 102 is operated within an inert enclosure 122 containing nitrogen or an inert gas to minimise oxidation of the organic semiconductor material. The design of the twin screw assembly can accommodate several more zones to mix and melt materials.

The use of a screw extruder apparatus allows the melting and mixing process to be carried out as a continuous process, as opposed to a batch process, which increases the efficiency of production of the precursor material. Also, as a result of the arrangement of zones along the length of the screw extruder, and the large proportion of the housing occupied by the screw or screws, this provides the advantage of enabling an efficient mixing process to be carried out, with minimal residence time of materials in the various zones, thus minimising the risk of degradation of the materials.

### Examples

### Comparative example 1

Bisphenol-A polycarbonate (PCA) can be dissolved in dichlorobenzene at the ratio of 6g to 40g dichlorobenzene. An additional amount of 4g hole transporting organic semiconductor, N,N'-Bisphenyl-N,N'-bis(3-methylphenyl)-benzidine (TPD) is added to the solution. The resulting solution is then wire bar coated to a wet thickness of 150 microns. Upon drying in a convection oven a solid film of 30 micron thickness is obtained. The absorption characteristics of such films are is similar to that of TPD itself as the PCA polymer has no significant absorption above the light wavelength of 250nm.

### Example 2 (not forming part of the present invention)

An 18mm twin screw compound extrusion apparatus as shown in figure 2 was cleaned by processing through pure polycarbonate. A rotary tube material feeder was installed for feeding the raw polycarbonate and calibrated to feed at 1.5g per minute. A separate dual screw powder feeder used to feed TPD, and calibrated at 1g per minute. The compounding twin extruder screws were running at 100rpm, purged and cleaned using clean polycarbonate for 5 minutes.

After this both PCA and TPD were fed into the system. The compound extrusion temperatures were set at optimized settings established experimentally so that both compounds were melted in the extruder and a uniform blend was obtained at the extruder output. PCA has a melting point of approximately 250C, while the melting point of TPD is approximately 170 C. The extruder was divided into five equal size zones along its length or 180 mm. At the feeding entry the temperature was set to 122 C, the second zone was set to 211 C, the third zone 225 C, the fourth zone to 230 C and finally at the exit die the temperature was 230C. The blend exiting the die formed a molten filament precursor of approximately 2mm diameter. The material became a continuous, flexible filament upon water cooling. This experiment resulted in a precursor solid material consisting of the blend of 40% TPD and 60% PCA, whilst eliminating the use of any solvent in the process.

### Example 3 (not forming part of the present invention)

The filament obtained in Example 2 was continuously fed into a cutting apparatus and cut into 3mm long pieces. The thus obtained material was dried at 100 C for 1.5 hours in a convection oven to obtain a pelletized precursor material. In total 58.6g of Polycarbonate, and 39g of TPD powder was used, from which we produced 104g of compounded material, due to some inaccuracy in the change over point from pure PCA to blending with TPD.

### Example 4 (not forming part of the present invention)

A single screw extruder as shown in Figure 1 was set up with a 500 micron wide and 25mm wide die at its exit. The precursor material obtained in Example 3 was fed continuously into the extruder with four temperature zones: Zone 1: 251 C (entry), Zone 2: 270 C, Zone 3 290 C, Die: 223 C.

The molten precursor was stretched and cast onto a steel roller of 75 mm diameter at the constant speed of 3.25 rpm. A film of 30 micron thickness and 15 mm width was obtained. Several metres of film were obtained, which consisted of approximately 40% TPD and 60% PCA. The film exhibited blue photoluminescence characteristic of the active semiconductor material TPD. Such films are employed, for example, in organic photoreceptors as hole transport layers.

It will be appreciated by persons skilled in the art that the above embodiments have been described by way of example only and not in any limitative sense, and that various alterations and modifications are possible without departure from the scope of the invention as defined by the appended claims. For example, the design of the extrusion screws can be any type. For example co-rotating conical screws having a special profile that kneads the ingredients as they are forced through the extruder can be used. Solid-state shear pulverization can also be employed as part of the process of blending to reduce the time the material is in the molten state. Other mixing apparatus may also be used as part of the design. In general it is desirable to reduce the residence time of the semiconductor materials at elevated temperatures. Therefore, it is desirable that the mixing volume in the twin screw or CTM mixers is small. This can be achieved by reducing the diameter of the mixing volume and ensuring that the highest temperatures are only briefly reached immediately before exiting the compounding process.

The resulting precursor material can be in the form of a molten stream, molten droplets, solid thread, solid particles, powder or aerosol droplets. The material in a molten state can be used to feed immediately a high temperature deposition process such as thermal inkjet, film extrusion, thermal transfer printing or hot lamination. The material exiting the blending/melt apparatus can optionally be allowed to cool to form a filament or thread of a material. Optionally water or other cooling material may be used. The filament can be cut into pellets if required. Alternatively, the blend exiting the process can be ejected to form droplets or a fine powder upon cooling. This can be assisted by the pressure and expansion of CO2 exiting with the material. In this case the final material can be collected and stored for further use or immediately fed into a coating process.

One or more of the materials in the preparation of the precursor can be an electron injection material. One or more of the deposited materials can be an electron transport material. One or more of the deposited materials can be light emitting material. One or more of the deposited materials can be a hole transport material. One or more of the deposited materials can be a hole injecting material. One or more of the deposited materials can be an exciton blocking material. One or more of the deposited materials can be a light absorbing material. One or more of the deposited materials can be a chemical sensing material. One or more materials can be a organic photoconductive dye or pigment. The deposited materials may be used as, for instance, semiconductors, light emitters, light absorbers, charge blockers, exciton blockers, used in, for instance, OLEDs, transistors, photodetectors, solar cells, and chemical sensors.

The semiconductor materials may be small molecule oligomeric or polymeric in nature. Any organic semiconductor material can be considered for the process to make precursors or precursor blends. Organic semiconductors are typically heteroaromatic molecules or polymers. Some chemical classes of organic semiconductors include thiophenes, oxidiazoles, perylenes, phthalocyanines, arylamines, carbazoles.

Some examples of small molecule materials are those used in the production of OLED components, such as electron transport layer (ETL) materials-Aluminum Tri (8-Hydroxyquinolinate) (Alq.sub.3); hole injection layer (HIL) materials-Copper Phthalocyanine (CuPc); hole transport (HTL) layer materials-N,N'-bisphenyl-N,N'-bis(1-naphthyl)-benzidine (abbreviated as NPB) or N,N'-Bisphenyl-N,N'-bis(3-methylphenyl)-benzidine (TPD), bathocuproine (BCP), or fac tris (2-phenylpyridine) iridium (Irppy). Pentacene or substituted pentacene derivatives may also be used.

Polymeric materials may be polythiophenes, polyvinylphenylenes (PVP), polyfluorenes, polyspiro or polycarbazole materials and the like. Any copolymer of consisting of active units of the above small molecule or polymeric semiconductor classes can also be considered.

The precursor blend may optionally contain inert binder polymers such as polystryrene, polycarbonate, polynaphthalene or their copolymers. Suitable binders are described for example, in US7576208 and US7095044. Binder polymers described in these documents are hereby incorporated by reference.

The precursor composition may also be prepared to contain dopants or additives to control carrier density or light emission. They can be conveniently added through the optional solvent feed. For example, by dissolving 0.1% dopant in 99% solvent and feeding it at 0.1 ml per minute compared to a 1 g per minute feed of solid materials doping ratios of 1:20000 can be achieved with accurate control. The doping ratio can also be adjusted continuously "on the fly" to supply a precursor blend for any coating process. The dopant or additive material may be an electron acceptor or donor, a dye controlling electroluminescence or any other aforementioned semiconductor material. A combination of two or more materials can also be sued in the solution feed. It is also possible to use two or more solution feeds into the mixing zone. Preferably the additive is dissolved in a solvent at a percentage of 0.001% to 40%, more preferably at 0.01% to 20% and most preferably at 0.1% to 10%. Any organic solvent can be used as a carrier to feed additives into the mixing zone.

## Claims

1. A method of manufacturing a precursor material for use in preparing at least one electroluminescent organic semiconductor device, the method **characterised by** melting at least one first organic semiconductor material including at least one electroluminescent material, and mixing at least one further material with the or each said first organic semiconductor material.

2. A method according to claim 1, wherein the step of melting at least one said first organic semiconductor material is carried out in the presence of at least one gas for minimising oxidation of at least one said first organic semiconductor material.

3. A method according to any one of the preceding claims, wherein at least one said further material comprises a plasticiser adapted to reduce the melting temperature of at least one said first organic semiconductor material.

4. A method according to claim 3, wherein the plasticiser comprises carbon dioxide.

5. A method according to claim 3 or 4, wherein the plasticiser comprises at least one supercritical fluid.

6. A method according to any one of the preceding claims, further comprising the step of removing at least some of said plasticiser subsequently to mixing thereof with at least one said first organic semiconductor material.

7. A method according to claim 6, wherein at least some of said plasticiser is removed by controlling the temperature and/or pressure of the melted material.

8. A method according to any one of the preceding claims, wherein at least one said further material comprises at least one second organic semiconductor material.

9. A method according to any one of the preceding claims, wherein at least one said further material is added in solution form.

10. A method according to any one of the preceding claims, wherein at least one said first organic semiconductor material includes at least one charge transport material.

11. A method according to any one of the preceding claims, wherein at least one said further material is added in solid form to at least one said first organic semiconductor material.

12. A method according to any one of the preceding claims, further comprising mixing at least one said first organic semiconductor material and at least one said further material by means of at least one screw extruder apparatus (2, 102).

13. A method according to claim 12, wherein at least one said screw extruder apparatus provides alternating zones ( 10, 12, 14, 16, 18; 108, 114) of high and low shear.

14. A method according to claim 12 or 13, wherein at least one said screw extruder apparatus includes at least one cavity transfer mixer (112).

## Patentansprüche

1. Verfahren zur Herstellung eines Vorläufermaterials zur Verwendung bei der Herstellung von wenigstens einem elektrolumineszenten organischen Halbleiterbauelement, wobei das Verfahren **gekennzeichnet ist durch** Schmelzen wenigstens eines ersten organischen Halbleitermaterials einschließlich wenigstens eines elektrolumineszenten Materials und **durch** Mischen von wenigstens einem weiteren Material mit dem oder jedem genannten ersten organischen Halbleitermaterial.

2. Verfahren nach Anspruch 1, wobei der Schritt des Schmelzens wenigstens eines genannten ersten organischen Halbleitermaterials in Anwesenheit von wenigstens einem Gas zum Minimieren von Oxidation von wenigstens einem genannten ersten organischen Halbleitermaterial durchgeführt wird.

3. Verfahren nach einem der vorherigen Ansprüche, wobei wenigstens ein genanntes weiteres Material einen Weichmacher enthält, um die Schmelztemperatur wenigstens eines genannten ersten organischen Halbleitermaterials zu reduzieren.

4. Verfahren nach Anspruch 3, wobei der Weichmacher Kohlendioxid enthält.

5. Verfahren nach Anspruch 3 oder 4, wobei der Weichmacher wenigstens ein überkritisches Fluid enthält.

6. Verfahren nach einem der vorherigen Ansprüche, das ferner den Schritt des Entfernens wenigstens eines Teils des genannten Weichmachers nach dem Mischen davon mit wenigstens einem genannten ersten organischen Halbleitermaterial beinhaltet.

7. Verfahren nach Anspruch 6, wobei wenigstens ein Teil des genannten Weichmachers durch Regeln der Temperatur und/oder des Drucks des geschmolzenen Materials entfernt wird.

8. Verfahren nach einem der vorherigen Ansprüche, wobei wenigstens ein genanntes weiteres Material wenigstens ein zweites organisches Halbleitermaterial enthält.

9. Verfahren nach einem der vorherigen Ansprüche, wobei wenigstens ein genanntes weiteres Material in Lösungsform zugegeben wird.

10. Verfahren nach einem der vorherigen Ansprüche, wobei wenigstens ein genanntes erstes organisches Halbleitermaterial wenigstens ein Ladungstransportmaterial enthält.

11. Verfahren nach einem der vorherigen Ansprüche, wobei wenigstens ein genanntes weiteres Material in fester Form zu wenigstens einem genannten ersten organischen Halbleitermaterial gegeben wird.

12. Verfahren nach einem der vorherigen Ansprüche, das ferner das Mischen von wenigstens einem genannten ersten organischen Halbleitermaterial und wenigstens einem genannten weiteren Halbleitermaterial mittels wenigstens einer Schueckenextrudervorrichtung (2, 102) beinhaltet.

13. Verfahren nach Anspruch 12, wobei wenigstens eine genannte Schneckenextrudervonichtung abwechselnde Zonen (10, 12, 14, 16, 18; 108, 114) von hoher und niedriger Scherung erzeugt.

14. Verfahren nach Anspruch 12 oder 13, wobei wenigstens eine genannte Schneckenextrudervorrichtung wenigstens einen Hohhlaumtransfermixer (112) aufweist,

## Revendications

1. Procédé de fabrication d'un matériau précurseur destiné à être utilisé dans la préparation d'au moins un dispositif à semi-conducteur organique électroluminescent, ce procédé étant **caractérisé par** la fusion d'au moins un premier matériau semi-conducteur organique comprenant au moins un matériau électroluminescent, et par le mélange d'au moins un autre matériau avec le ou chaque dit premier matériau semi-conducteur organique.

2. Procédé selon la revendication 1, dans lequel l'étape de fusion d'au moins un dit premier matériau semi-conducteur organique est effectuée en la présence d'au moins un gaz pour minimiser l'oxydation d'au moins un dit premier matériau semi-conducteur organique.

3. Procédé selon l'une quelconque des revendications précédentes, dans lequel au moins un dit autre matériau consiste en un plastifiant adapté de façon à réduire la température de fusion d'au moins un dit premier matériau semi-conducteur.

4. Procédé selon la revendication 3, dans lequel le plastifiant comprend du dioxyde de carbone.

5. Procédé selon la revendication 3 ou 4, dans lequel le plastifiant comprend au moins un fluide supercritique.

6. Procédé selon l'une quelconque des revendications précédentes, comprenant en outre l'étape consistant à enlever au moins une partie dudit plastifiant après avoir mélangé celui-ci avec au moins un dit matériau semi-conducteur organique.

7. Procédé selon la revendication 6, dans lequel au moins une partie dudit plastifiant est enlevée en contrôlant la température et/ou la pression du matériau fondu.

8. Procédé selon l'une quelconque des revendications précédentes, dans lequel au moins un dit autre matériau comprend au moins un deuxième matériau semi-conducteur organique.

9. Procédé selon l'une quelconque des revendications précédentes, dans lequel au moins un dit autre matériau est ajouté sous forme de solution.

10. Procédé selon l'une quelconque des revendications précédentes, dans lequel au moins un dit premier matériau semi-conducteur organique comprend au moins un matériau de transport de charge.

11. Procédé selon l'une quelconque des revendications précédentes, dans lequel au moins un dit autre matériau est ajouté sous forme solide à au moins un dit premier matériau semi-conducteur organique.

12. Procédé selon l'une quelconque des revendications précédentes, comprenant en outre le mélange d'au moins un dit premier matériau semi-conducteur organique et d'au moins un dit autre matériau au moyen d'au moins un appareil extrudeur à vis (2, 102).

13. Procédé selon la revendication 12, dans lequel au moins un dit appareil extrudeur à vis fournit des zones alternées (10, 12, 14, 16, 18 ; 108, 114) de cisaillement élevé et faible.

14. Procédé selon la revendication 12 ou 13, dans lequel au moins un dit appareil extrudeur à vis comprend au moins un mélangeur de transfert à cavités (112).
